# EUROPEAN PATENT APPLICATION

(11) **EP 1 873 814 A2**
(43) Date of publication of application: **02.01.2008**
(21) Application number: 07012386.4
(22) Date of filing: 25.06.2007
(51) Int. Cl.: H01L 21/02, H01L 21/768

(54) **Hermetic passivation layer structure for capacitors with perovskite or pyrochlore phase dielectrics**

(30) Priority: 28.06.2006 US 817033 P
(71) Applicant: GENNUM CORPORATION, Burlington, Ontario L7L 5P5 (CA)
(72) Inventor: Zelner, Marina, Burlington, Ontario L7S 2A1 (CA); Woo, Paul Bun Cheuk, Mississauga, Ontario L5A 3N6 (CA)
(74) Representative: Jones Day

(57) **Abstract**

A thin-film capacitor structure fabricated on a substrate is provided. The thin-film capacitor includes a pyrochlore or perovskite alkali earth dielectric layer between a plurality of electrode layers. A pyrochlore or perovskite hydrogen-gettering barrier layer is deposited over the thin-film capacitor. A hermetic seal layer is deposited over the barrier layer by plasma enhanced chemical vapor deposition (PECVD), low pressure chemical vapor deposition (LPCVD), or some other hydrogen-producing method. The hydrogen-gettering barrier layer prevents hydrogen from reacting with and degrading the properties of the dielectric material, thereby enhancing the durability and other features of the capacitor.

## Description

### FIELD

The technology described in this patent document relates generally to the field of thin-film devices and fabrication. More particularly, the patent document describes a thin-film capacitor structure having a hermetic passivation layer structure that includes a hydrogen barrier or gettering layer and a method of manufacturing the same.

### BACKGROUND

Thin-film circuit modules are commonly used in space-constrained applications, such as hearing instrument or cell phone products. In some thin-film circuit modules, perovskite or pyrochlore materials, such as (BaₓSr_{y})TiO₃ (hereinafter BST), are used as high K capacitor dielectrics. The high dielectric constant of these materials allows for significant miniaturization of these devices. Many capacitors can also be fabricated on a single substrate along with other passive electronic components (integrated passive component chips) to form part of cellphone power amplifier modules, GPS receivers, etc.

Moisture affects pyrochlore and perovskite dielectric capacitors adversely, causing increased leakage and significantly degrading performance and shortening the lifetime of the device. Thus, either a hermetic package must be provided, or the chip must incorporate hermetic sealing layers to prevent moisture penetrating to the perovskite dielectric. For cost purposes, most applications incorporate a hermetic sealing layer.

Currently known methods for providing a hermetic seal and scratch protection include either a low-temperature plasma-enhanced chemical vapor deposition (PECVD) or high-temperature/low pressure deposition chemical vapor deposition process (LPCVD) of silicon nitride. These processes result in the production of a significant amount of atomic hydrogen.

Some of the hydrogen produced during the typical LPCVD and PECVD processes reacts with the perovskite or pyrochlore dielectric material and causes an increased leakage current in the capacitor. The lifetime of a capacitor is inversely related to leakage current. The LPCVD and PECVD processes, while useful for providing a hermetic seal and scratch protection, also cause a decrease in the lifetime of the capacitor, due to the effect of the hydrogen produced by these processes on the perovskite or pyrochlore materials.

### SUMMARY

The technology described herein provides a barrier layer to shield the dielectric from the harmful effects of the hydrogen released in the LPCVD or PECVD process.

A thin-film capacitor structure includes a substrate with a thin-film capacitor attached to the substrate. The thin-film capacitor includes a pyrochlore or perovskite dielectric layer between a plurality of electrode layers, the electrode layers being formed from a conductive thin-film material. A pyrochlore or perovskite alkali earth titanate hydrogen-gettering barrier layer is deposited over the thin-film capacitor. In addition, a silicon nitride layer is deposited over the barrier layer, the silicon nitride layer being deposited by plasma enhanced chemical vapor deposition (PECVD) or low pressure chemical vapor deposition (LPCVD).

An integrated circuit includes a substrate and a capacitor that includes a pyrochlore or perovskite dielectric layer between a plurality of electrode layers. A pyrochlore or perovskite alkali earth titanate hydrogen-gettering barrier layer is also deposited over the thin-film capacitor. Furthermore another layer is deposited by a process that produces atomic hydrogen in a quantity sufficient to degrade the capacitor.

A method of manufacturing a capacitor structure includes the steps of: fabricating a capacitor on a substrate, the capacitor having a pyrochlore or perovskite dielectric layer; depositing a pyrochlore or perovskite alkali earth titanate hydrogen-gettering layer over the capacitor; and depositing a silicon nitride hermetic seal layer by PECVD or LPCVD over the hydrogen barrier layer.

### BRIEF DESCRIPTION OF THE DRAWINGS

Figure 1 is a diagram of an example thin-film capacitor fabricated on a substrate.
Figure 2 is a diagram of the example thin-film capacitor of Fig. 1, including an insulating and/or planarizing layer.
Figure 3 is a diagram of the example thin-film capacitor of Fig. 2, including a hydrogen barrier layer.
Figure 4 is a diagram of the example thin-film capacitor of Fig. 3, including an insulating layer.
Figure 5 is a diagram of the example thin-film capacitor of Fig. 4, including via holes etched in the interlayer dielectric (ILD) layer.
Figure 6 is a diagram of the example thin-film capacitor of Fig. 5, including an interconnect layer.
Figure 7 is a diagram of the example thin-film capacitor of Fig. 6, including a hermetic seal layer.
Figure 8 is a diagram of the example thin-film capacitor of Fig. 7, including a package interconnect layer.
Figure 9 is a diagram of an example thin-film capacitor having a via etched in the ferroelectric layer.
Figure 10 is a diagram of the example thin-film capacitor of Fig. 9, including insulating and/or planarizing layers.
Figure 11 is a diagram of the example thin-film capacitor of Fig. 10, including via holes etched in an ILD layer.
Figure 12 is a diagram of the example thin-film capacitor of Fig. 11, including an interconnect layer.
Figure 13 is a diagram of the example thin-film capacitor of Fig. 12, including a hydrogen barrier layer.
Figure 14 is a diagram of the example thin-film capacitor of Fig. 13, including a hermetic seal layer.
Figure 15 is a diagram of the example thin-film capacitor of Fig. 14, including a package interconnect layer.
Figure 16(a) is a diagram of the example thin-film capacitor of Fig. 15, but with a different package interconnect layer.
Figure 16(b) is a diagram of the example thin-film capacitor of Fig. 8, but with a different package interconnect layer.
Figure 17 is a diagram of an example multi-level thin-film capacitor having a hydrogen barrier integrated into the final passivation layer.
Figure 18 is a diagram of an example multi-level thin-film capacitor having a hydrogen barrier integrated into the ILD film stack.
Figure 19 is a diagram of an example thin-film capacitor having a hermetic sealing layer integrated part of the ILD film stack.
Figure 20 is a diagram of the example thin-film capacitor of Fig. 19 including via openings etched into the ILD film stack.
Figure 21 is a diagram of the example thin-film capacitor of Fig. 20 including a final protection layer and package interconnects.
Figures 22 and 23 illustrate an example process for fabricating an example circuit structure.

### DETAILED DESCRIPTION

Described herein are example structures and methods for providing a hydrogen barrier layer to a capacitor structure that incorporates perovskite or pyrochlore materials as a dielectric. This barrier helps prevent degrading of the leakage current of the perovskite or pyrochlore dielectric that results from the absorption of hydrogen that is released from silicon nitride deposition processes such as conformal methods that enable the deposition of dense pin-hole-free films, such as: plasma-enhanced (PECVD) or low-pressure (LPCVD) chemical vapor deposition. Accordingly, the durability and reliability of the capacitor is improved.

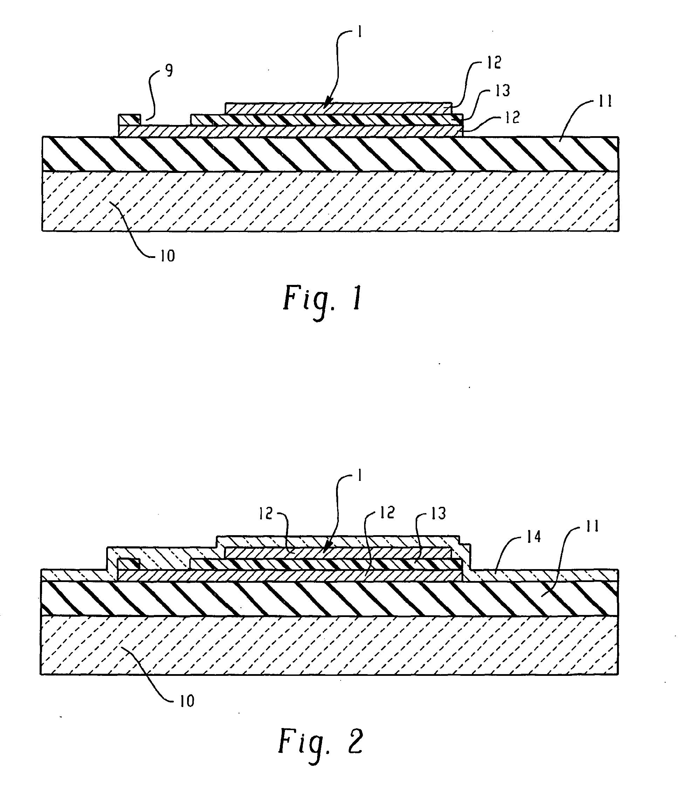

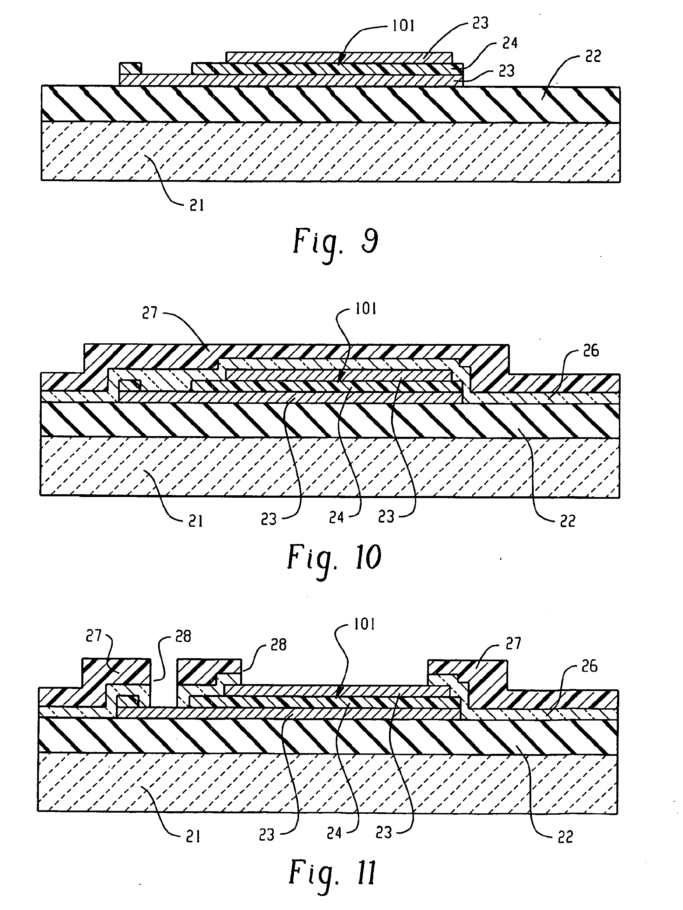

The barrier in the structures described herein includes a layer of perovskite or pyrochlore material, for example an alkali earth titanate dielectric, such as BST, BaTiO₃, CaTiO₃, SrTiO₃, BeTiO₃, MbTiO₃ or a mix of these. This barrier should be inserted into the structure comprising the passivation of the capacitor before the silicon nitride is deposited. This layer then absorbs or getters the hydrogen which is produced during the CVD process and prevents it from reaching the capacitor dielectric, thus lessening degradation of the capacitor properties. Figs. 1-8 show the integration of the barrier layer into the inter-layer dielectric stack, and Figs. 9-15 show the barrier layer being used as part of the final passivation layer.

The example structures and methods described herein allow for a variety of process options to be used with the dielectric layer and facilitate optimizing of the dielectric layer. The subject of this disclosure also allows further processing of the structure to integrate other passive components such as inductors, resistors, and capacitors with other dielectric materials. The circuit structures described herein, may, for example, be used in a system-on-a-package (SoP) structure for hearing instrument products or other products requiring high volumetric density for capacitors and other integrated passives (e.g., inductors, resistors) in radio frequency (RF), Bluetooth, and high-speed wireless (e.g., wideband) communication modules.

Figure 1 is a diagram of an example thin-film capacitor 1 fabricated on a substrate 10. Also illustrated in Figure 1 is an insulating and/or planarizing layer 11 that is fabricated between the substrate 10 and the thin-film capacitor 1.

The thin-film capacitor 1 includes one or more layers of high permittivity dielectric perovskite or pyrochlore material 13 (e.g., compounds containing Barium Strontium Titanium Oxide or (BaSr)TiO₃ also known as BST, SBT, SBM, PZT or PLZT) deposited between electrode layers 12 formed from a conductive thin-film material (e.g., Pt, conductive oxides like SrRuO3, LaNiO3, LaMn₁₋ₓCoₓO3, etc., other metals, like Au, Cu, W, etc.). The thin-film capacitor 1 can be fabricated with a variety of capacitance-voltage characteristics depending on the material properties and processing conditions of the whole stack. The thin-film capacitor 1 may include one or more voltage variable (tunable) capacitors and/or fixed value capacitors, depending on the type of dielectric material used for the dielectric layer or layers. The thin-film capacitor 1 may be a mesa-structure formed using photolithography patterning. A via hole 9 is etched in the perovskite or pyrochlore dielectric layer to allow access for a contact to the bottom electrode.

The substrate 10 may, for example, be Si, Al₂O₃, sapphire AIN, MgTiO₃, Mg₂SiO₄, GaAs, GaN, SiC or some other insulating, semi-insulating, or semi-conducting material, either polycrystalline or mono-crystalline. Ceramic substrate materials are typically inexpensive and are highly machinable. A ceramic substrate 10 may therefore include fine-pitched metal filled through holes that provide low and controlled parasitics. In addition, a ceramic substrate material provides substantially better Q-factors for other passive components (e.g. thin-film inductors) than conventional silicon-based substrates.

A smooth surface sufficient for fabricating the thin-film capacitor is provided by the planarizing and/or insulating layer 11. In another example, the thin-film capacitor 1 may be fabricated directly on the substrate; however, the fabrication of a high value thin-film capacitor (e.g., with an overall capacitance density from 10 to 390 fF/µm²), requires a high degree of precision, and this is difficult to achieve with some rough substrate materials such as ceramic. Therefore, the planarizing layer 11 allows for increased precision. It may also facilitate better adhesion of the capacitor 1 to the substrate 10.

The planarizing and/or insulating layer 11 may be a thick film dielectric material that is polished to provide a smooth upper surface. In another example, this layer 11 may be a smooth (fire polished) glass dielectric material. In the case of a polished thick film layer 11, the surface roughness (Ra) of the smooth upper surface may be less than or equal to 0.08 micrometers (µm), but is preferably less than or equal to 0.06 µm. In the case of a glass dielectric smooth and/or insulating layer 11, the surface roughness (Ra) of the smooth upper surface may be less than or equal to 0.08 µm, but is preferably less than or equal to 0.03 µm. In addition to providing a low surface roughness (e.g., Ra ≤ 0.08 µm), this layer 11 is substantially free of micropores and is thus stable at high temperatures. For example, the smooth and/or insulating layer 11 may be able to withstand multiple anneals at high temperatures (e.g., 600-800° C) in an oxidizing atmosphere without substantially affecting its surface quality or the resistivity of any metal filled vias. As a result, the high-k ferroelectric layer(s) of the MLC 14 may be deposited using a simple spin-coat technology, as well as methods such as Physical Vapor Deposition (PVD) or Chemical Vapor Deposition (CVD).

Figure 2 is a diagram of the example multi-level thin-film capacitor 1 of Fig. 1, fabricated on a substrate 10 including an optional insulating and/or planarizing layer 14, such as spin-on-glass, deposited by a hydrogen free process. An example capacitor may be fabricated without the insulating and planarizing layer 14; however, including this layer 14 allows for a smooth topography that is more amenable to sputtering techniques.

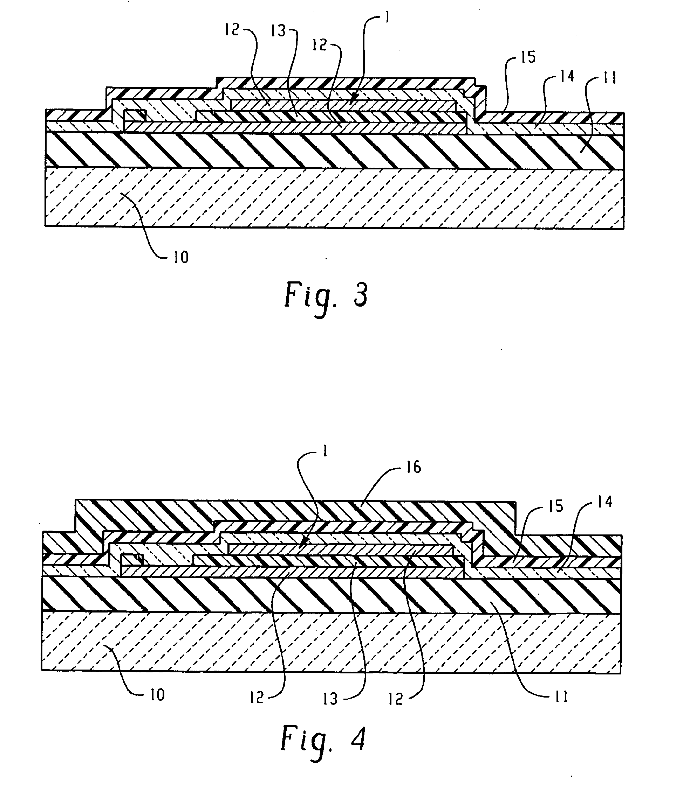

Figure 3 is a diagram of the example thin-film capacitor 1 of Fig. 2 fabricated on a substrate 10, and overlaid with an insulating and planarizing layer 14, and including a hydrogen barrier layer 15. As mentioned above, the hydrogen barrier layer 15 may be any perovskite or pyrochlore material, for example a single alkali earth titanate dielectric or a mix of these. In this example, this layer may be anywhere from 50 nm to 1 micron thick. However, other thicknesses may also be used. This barrier layer 15 is incorporated into the layer stack of the capacitor before the hermetic seal silicon nitride layer is deposited. The barrier layer 15 can be mono-crystalline, polycrystalline, or amorphous. This layer 15 functions to absorb or getter the hydrogen which is produced during the silicon nitride CVD process, and prevents the hydrogen from reaching the capacitor dielectric 13, thus greatly reducing or eliminating the degradation of the capacitor leakage current caused by hydrogen contamination. The barrier layer 15 may be fabricated with the same material as the dielectric layer 13 of the capacitor 1. The barrier layer 15 can be deposited by sputtering. It may also be deposited with other known methods such as metal-organic chemical vapour deposition (MOCVD), pulsed-laser deposition (PLD), etc.

The barrier layer 15 enables a wide variety of process options for the dielectric 13, such as the temperature of deposition and electrode quality. Because of the separate barrier layer 15 the perovskite or pyrochlore dielectric 13 can be processed to specified optimum performance characteristics, and these characteristics will be substantially unaltered from reaction with hydrogen after hermetic sealing. Furthermore, using the pyrochlore or perovskite barrier 15 allows for further processing to integrate other passive components such as inductors, resistors, and capacitors with other dielectric materials.

The barrier layer 15 allows oxygen to diffuse through it, thereby allowing damage to the active layer from subsequent processes to be repaired. For example, damage to the active layer resulting from processes such as ion milling or other dry etch techniques can be repaired. The barrier layer 15 described herein allows for a capacitor that is robust against assembly processes such as sawing, solder reflow, epoxy encapsulation and assembly onto the customer board. The layer 15 is thin, electrically inactive, and has no adverse effect on the circuit performance.

Figure 4 illustrates the structure of Fig. 3 with an additional insulating layer 16. The insulating layer 16 may, for example, be phosphosilicate glass (PSG), SiO₂, Si₃N₄or some other suitable dielectric material. This layer provides low parasitic capacitance and may constitute a majority of the thickness of the structure. Layer 16 insulates the interconnect metal lines (discussed below) from the upper and lower electrodes 12.

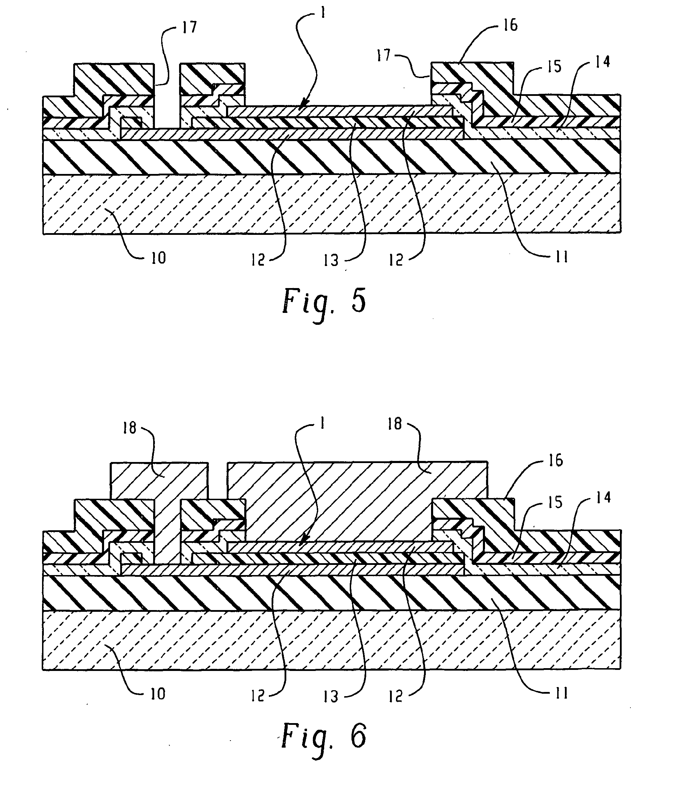

Figure 5 depicts the structure of Fig. 4 further including vias 17 etched in the interlayer dielectric (ILD) structure allowing contact to both the top and bottom electrodes 12.

Figure 6 shows the structure of Fig. 5 with an interconnect layer 18 deposited in the vias 17 and making contact with the upper and lower electrodes 12. In this example, the vias 17 are filled with metal to provide a low-resistance interconnect between the components on the substrate and to the input/output pads for connection to other circuits. The interconnect layer 18 must extend past the edges of the vias 17 for the hermetic seal to be effective. The interconnect layer 18 may, for example, be TiW/Al/TiW, TiW/Al, TiW/Au, TiN/Al, Ti/TiN/Al, Ti/TiW/Cu or TiW/Cu.

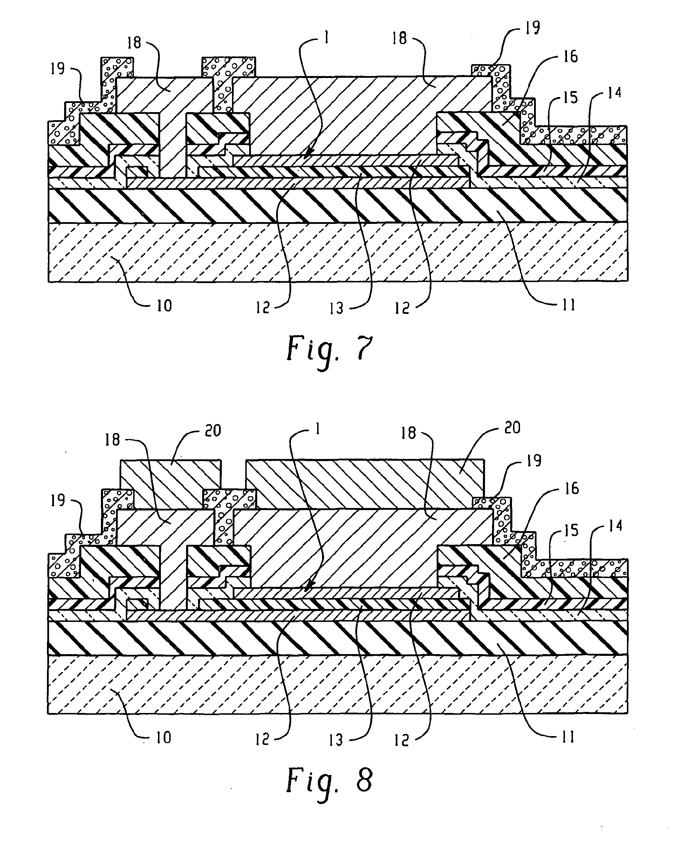

In Figure 7, a layer of silicon nitride 19 is deposited and patterned on the structure of Fig. 6. This layer 19 functions as a hermetic seal to keep out moisture that would degrade the performance of the capacitor 1. As discussed above, this layer may be deposited by PECVD or LPCVD. These processes produce atomic hydrogen that is shielded from the dielectric layer 12 by the barrier layer 15.

Figure 8 shows a conducting portion 20 added onto the structure of Fig. 7 that may, for example, be used to electrically connect the structure to an integrated circuit (IC) chip to form a system-on-a-package structure. Gold, copper, or solder bumps are examples of materials that may be used for this portion 20, but other conductive materials may also be used. In other examples this layer may not be present.

Figure 9 is a second example thin-film capacitor 101 fabricated on a substrate 21 with an insulating and/or planarizing layer 22. The capacitor 101 has a pyrochlore or perovskite dielectric layer 24 flanked by conducting electrodes 23 and a via 25 etched in the dielectric layer 20. Figure 9 is the same as Figure 1 except for the numbering, but is presented separately to more clearly explain the subsequent figures and how they differ from Figs. 1-8.

Figure 10 depicts two additional layers added to the structure of Fig. 9. The first added layer is an optional insulating and/or planarizing layer 26 that is identical to the one first illustrated in Fig. 2 and described in the accompanying description of Fig. 2. Over the insulating and/or planarizing layer 26 is an insulating layer 27 that is identical to the one first illustrated in Fig. 4 and described in the accompanying description of Fig. 4. A difference between the first example capacitor shown in (Figs. 1-9) and the second example capacitor (shown in Figs. 10-15) is that the barrier layer 15 is between the insulating and planarizing and insulating layers in the first example capacitor, and these two layers are adjacent in the second example capacitor.

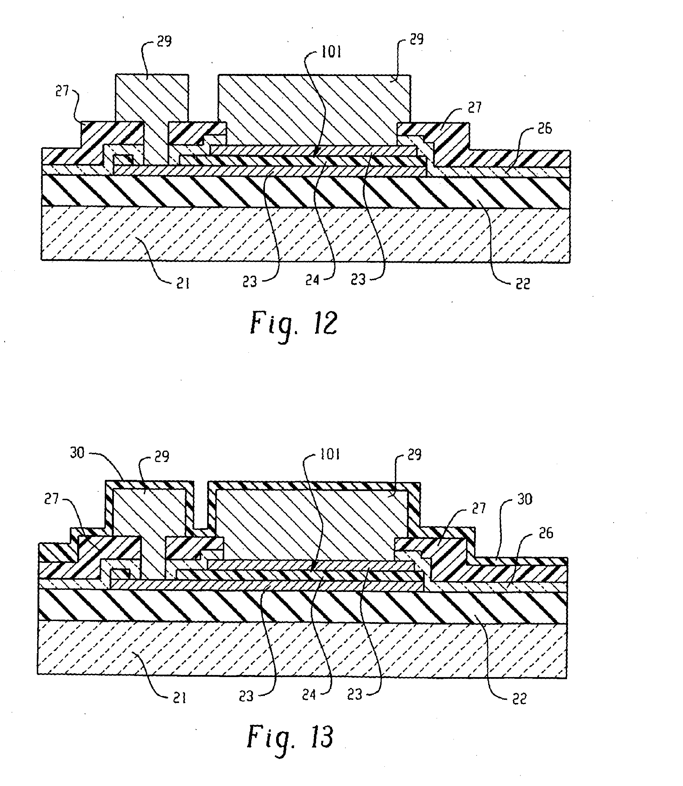

Figure 11 shows vias 28 etched in the structure of Fig. 10 so that the upper and lower electrodes 23 are exposed for contact.

Figure 12 illustrates the structure of Fig. 11 with an interconnect layer deposited in the vias and contacting the upper and lower electrodes 23.

Figure 13 shows the structure of Fig. 12 with the addition of the barrier layer 30 deposited conformally over the interconnects and ILD. Notably, the barrier layer 30 is deposited much later in this example capacitor structure than in the first example capacitor of Figs. 1-8. However, the barrier layer 30 is effective so long as it is deposited before the silicon nitride hermetic seal layer is deposited.

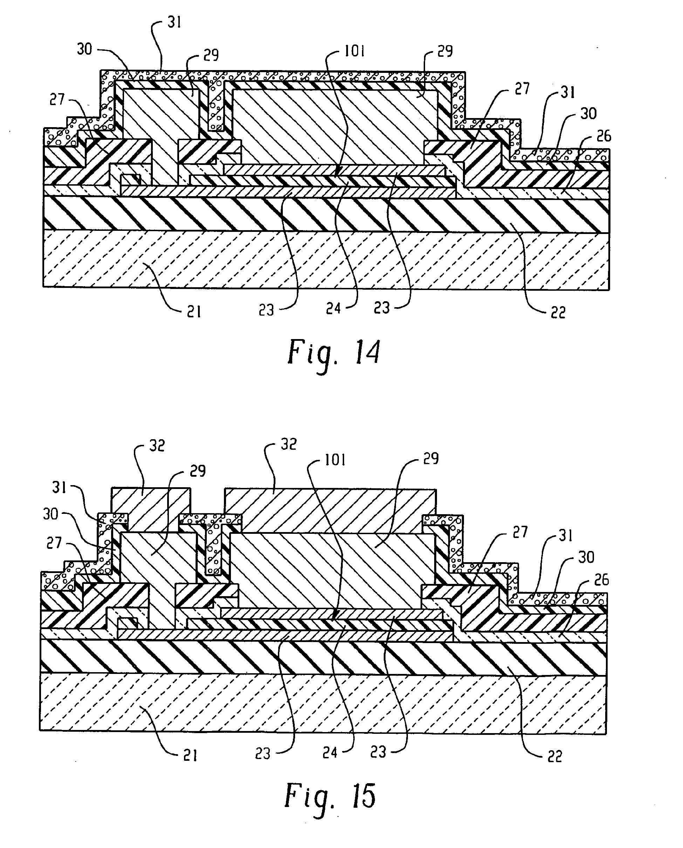

In Figure 14 the conformal layer of silicon nitride 19 is deposited by PECVD or LPCVD and is patterned on the structure of Fig. 13. As discussed above, this layer 31 functions as a hermetic seal to keep out moisture that would degrade the performance of the capacitor 101. The barrier layer shields the perovskite or pyrochlore dielectric 24 from hydrogen released from the PECVD or LPCVD process.

Figure 15 shows an additional conducting portion 32 added onto the structure of Fig. 14 that functions as an interconnect to the package. Gold, copper, or solder bumps are examples of materials that may be used for this portion 32, but other conductive materials may also be used. In other examples this layer may not be present, or could be used as a second layer of interconnect.

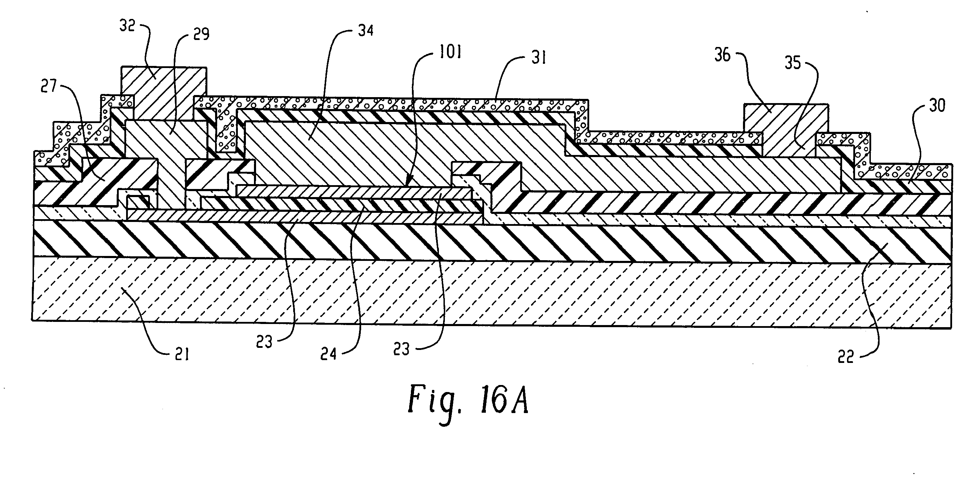

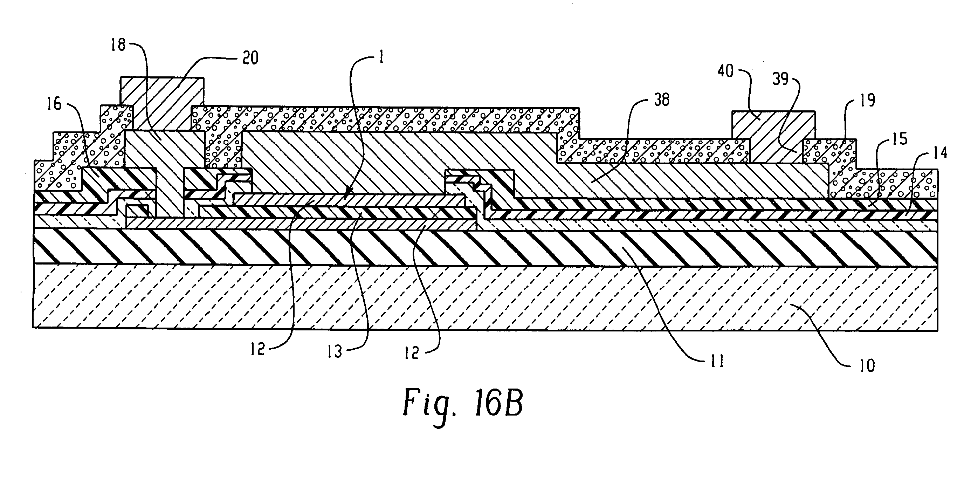

Figures 16 (a) and (b) depict alternate configurations of perovskite or pyrochlore capacitors having different metal connections 34 and 38 to the top electrode of the electrode pairs 23 and 12, respectively. Figure 16(a) is similar to Fig. 15 in that the hydrogen barrier 30 is integrated into the ILD film stack. The structure in Fig. 16(a), however, has a different metal interconnect 34 that leads from the top electrode 33 to a pad opening 35 that is spaced laterally away from the capacitor 101 and is filled with a conducting portion 36, such as gold, copper, or a solder bump. In Figure 16(b) the hydrogen barrier 15 is integrated into the final passivation layer as in Fig. 8, however, the structure of Fig. 16(b) has a different metal interconnect 38 that leads from the top electrode 37 to a second pad opening 39 that is spaced laterally away from the capacitor 1 and is filled with a conducting portion 40, such as gold, copper, or a solder bump. In other examples similar to the structures shown in Figs. 16(a) and (b), the conducting portions 36, 40 may not be present.

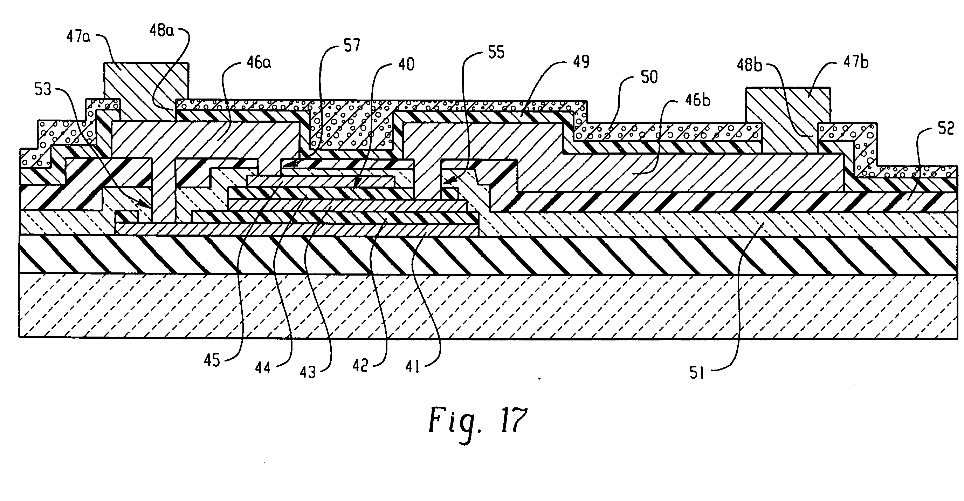

Fig. 17 shows an example multi-level capacitor 41 that has a bottom 41, middle 43, and top electrode 45, and a lower 42 and upper 44 pyrochlore or perovskite dielectric. The lower dielectric 42 being flanked by the bottom 41 and middle 43 electrodes, and the upper dielectric 44 being flanked by the middle 43 and top 45 electrodes. Each layer of the multi-level capacitor structure 41 can have different properties and functions which may include different capacitance-voltage characteristics (tunabilities). The multi-level capacitor structure 41 is a mesa-structure, which may be fabricated using photolithography based patterning techniques. Preferably, the capacitor formed from the top two conductive electrodes 43, 45 and the top-most dielectric layer 44 is a voltage variable (tunable) capacitor.

An insulating and/or planarizing layer 51 is deposited over and adjacent to the capacitor 40, and a thick insulating layer 52 is deposited over and adjacent to the insulating and/or planarizing layer 51. (More detailed descriptions of these layers are discussed above.) Vias are etched through the thick insulating layer 52, the insulating and/or planarizing layer 51, and the lower 42 and upper 44 dielectrics. A first via 53 is etched so that the bottom electrode 41 is exposed. A second via 55 is etched so that the middle electrode 43 is exposed. A third via 57 is etched so that the top electrode 45 is exposed. A first interconnect portion 46a is conformally deposited over a section of the thick insulating layer 52 and into the first 53 and third vias 57. A second interconnect portion 46b is also conformally deposited over another section of the thick insulating layer 52 and into the second via 55. In this example, the interconnect portions 46a, 46b are metals that provide a low-resistance interconnect between the components of the capacitor 40 and input/output pads for connection to other circuits. The interconnect portions 46a, 46b may, for example, be TiW/Al/TiW, TiW/Al, TiW/Pt/Au, TiN/Al, Ti/TiN/Al, Ti/TiW/Cu or TiW/Cu. The BST barrier layer 49 and Silicon Nitride overcoat 50 are fabricated over the first and second interconnect portions 46a, 46b and the remaining exposed section of the thick insulating layer 52. Conductive portions 47a and 47b fill pad openings 48a and 48b in the barrier layer 49 and the silicon nitride layer 50. The conducting portions 47a, 47b may, for example, be gold, copper, or solder bumps. In other examples, the pad openings 47a, 47b may not be filled with a conducting portion.

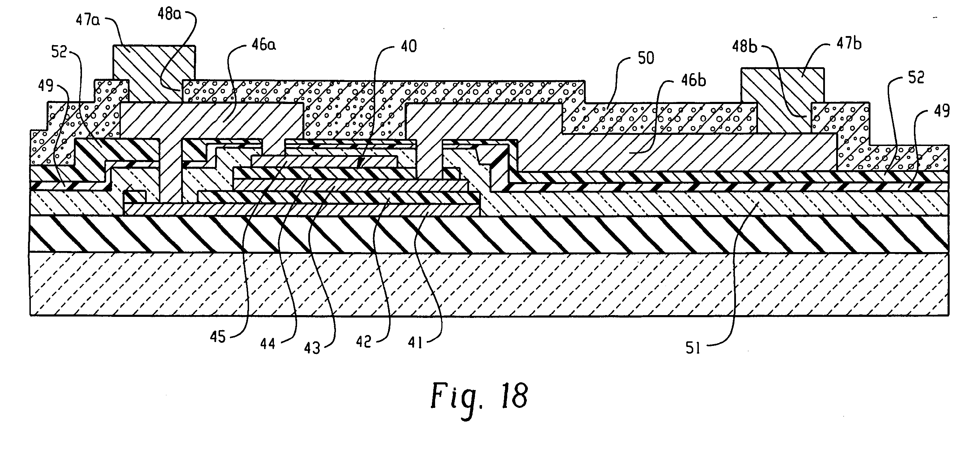

Figure 18 is the same as Figure 17 except that the hydrogen barrier 49 is integrated into the ILD film stack, being sandwiched between the insulating and/or planarizing layer 51 and the thick insulating layer 52.

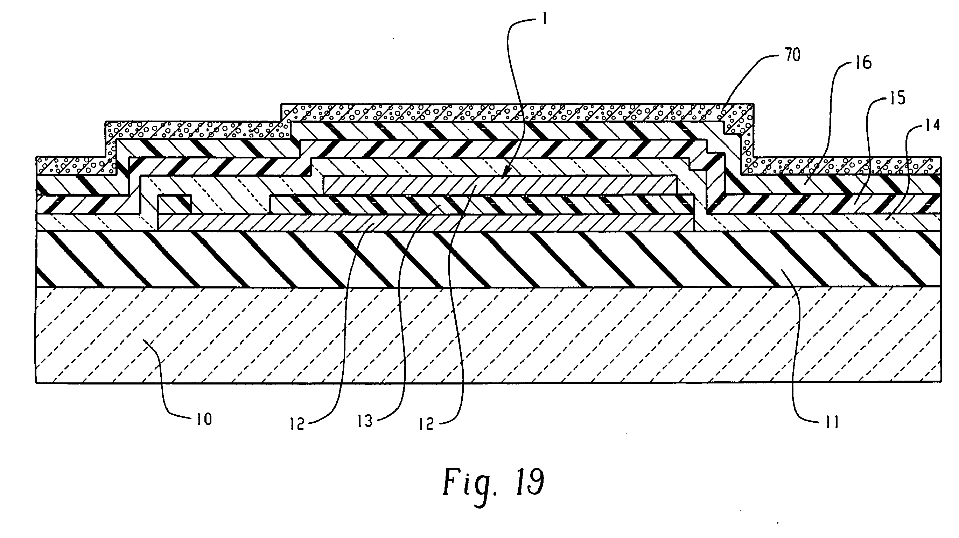

Figure 19 shows the structure of Fig. 4, with a hermetic sealing layer 70 applied as part of the ILD film stack before any via hole processing is performed.

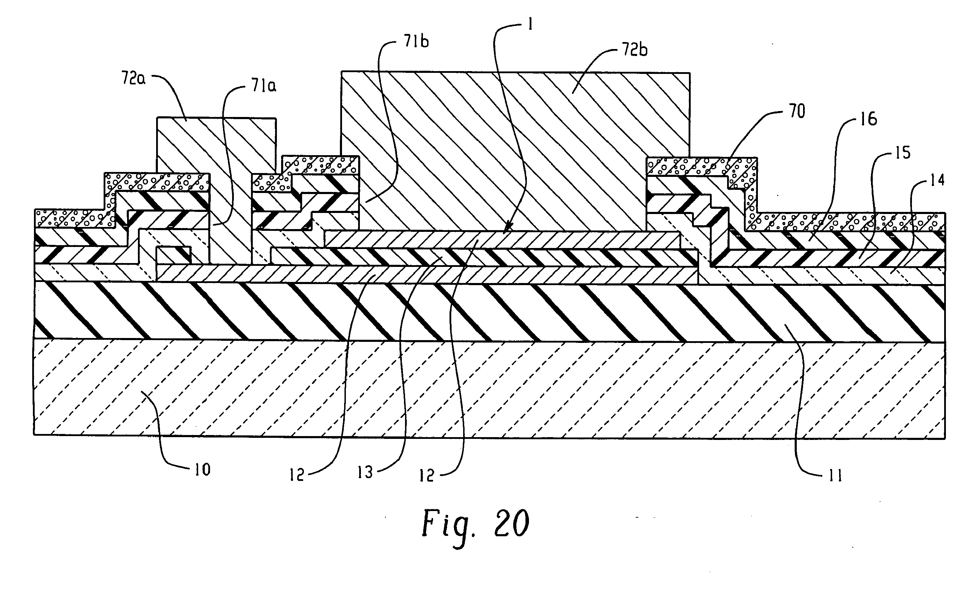

Figure 20 shows the structure of Fig. 19 with first and second vias 71a, 71b etched into the ILD film stack and filled with first and second interconnecting portions 72a, 72b. The first via 71a allows the first interconnect portion 72a to contact the lower electrode 12, and the second via 71 b allows the second interconnect portion 72b to contact the upper electrode 12.

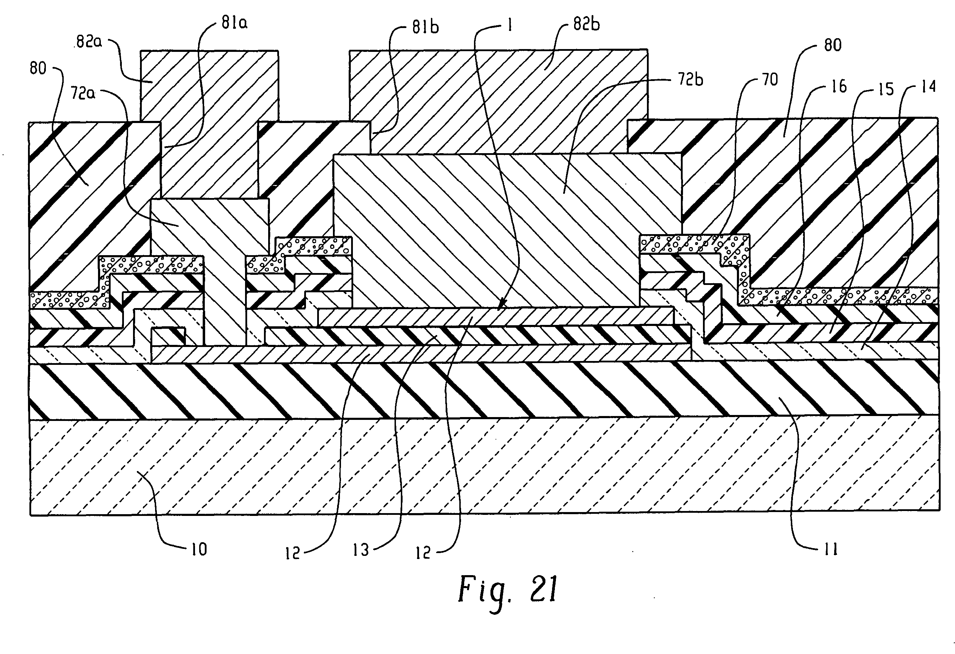

Figure 21 shows the structure of Fig. 20 with an additional final protection layer 80 deposited and patterned to allow first and second conducting portions 82a, 82b to contact the first and second interconnect portions 72a, 72b, The final protection layer 80 provides protection to the capacitor from scratches or other damage. The first and second conductor portions 82a, 82b protrude through first and second pad openings 81 a, 81 b that are etched in the final protection layer 80 and may provide contact to external circuits. Example materials used for the final protection layer 80 are cyclobutane or polyimide. The conductor portions 82a, 82b may, for example, be gold, copper, or solder bumps.

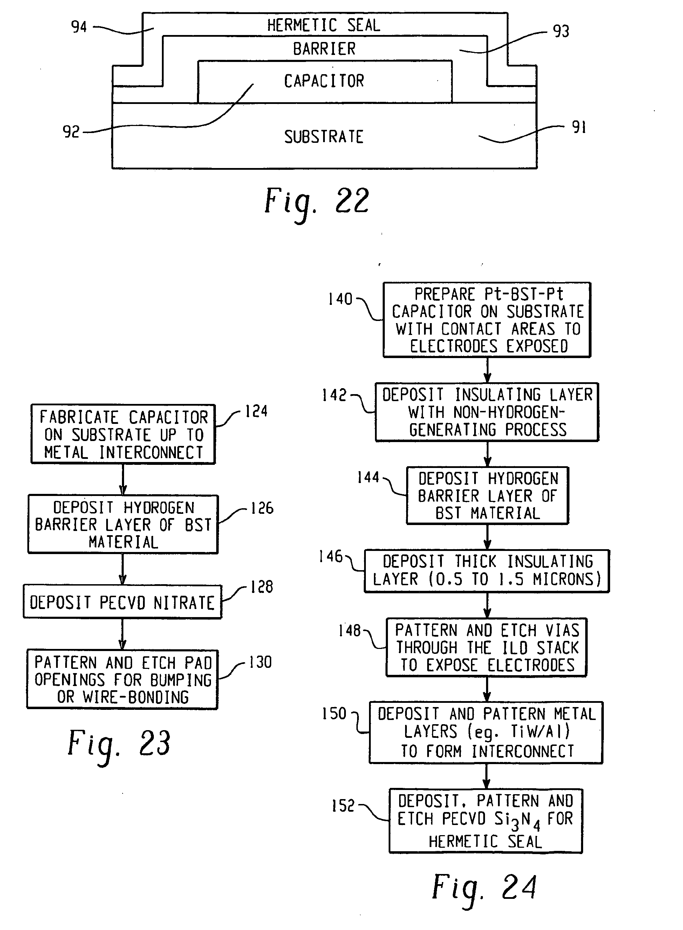

In other examples of the technology described herein, any of the above described structures could be fabricated without the insulating and/or planarizing layer and/or the thick insulating layer. In these examples it is contemplated that the pyrochlore or perovskite hydrogen barrier layer could partially overlay and contact the pyrochlore or perovskite dielectric of the capacitor. Figure 22 illustrates such an example structure where a substrate 91 is attached to a capacitor 92, and a barrier layer 93 and hermetic seal 94 are sequentially deposited over the capacitor 92. Other layers may be added to the structure of Fig. 22 such as planarizing, insulating, or interconnect layers, as discussed above. Layers promoting adhesion of the capacitor to the substrate or planarizing layer, buffer layers, and high density interconnect (HDI) layers are also examples of layers that may be added to the structure to provide additional enhanced characteristics or functionality. Vias may be fabricated in various locations though the respective layers to provide contact points for conducting components, for example, to attach the capacitor 92 to the package.

Figures 23-24 illustrate example processes for fabricating an example circuit structure that incorporates a hydrogen barrier layer. Fig. 23 is a flow diagram illustrating a general fabrication process for a basic structure incorporating the hydrogen barrier, and Fig. 24 illustrates a more detailed fabrication process for a structure with additional layers.

Regarding Figure 23, the overall, process for fabricating an example circuit structure is illustrated as a four step process. In the first step 124, a thin-film capacitor is fabricated on a substrate and metal interconnects are provided. In the second step 126, the BST hydrogen barrier layer is fabricated over the capacitor. In the third step 128, silicon nitride is deposited by PECVD over the BST hydrogen barrier layer. The atomic hydrogen produced from the PECVD process is blocked from reaching the capacitor by the blocking layer. In the fourth step 130, the structure is patterned and etched to create pad openings for bumping or wire-bonding.

With reference now to Figure 24, in the first step 140, a Pt-BST-Pt capacitor is fabricated on a substrate so that contact areas to the electrodes are exposed. The contact area to the bottom electrode may be formed by etching away the BST and/or top electrode layers to form a via. This step may also include the fabrication of the substrate, such as a ceramic substrate with HDI routing, and also an insulating and/or planarizing layer on the side of the substrate that the capacitor is fabricated on. The second step 142 involves depositing an insulating layer over the capacitor with a non-hydrogen-generating process. The insulating layer may also function to smooth the topography of the structure. In the third step 144 the BST hydrogen barrier layer is deposited over the structure. Then, in the fourth step 146, a thick insulating layer is deposited. This layer may be 0.5 to 1.5 microns thick, and may provide the majority of the thickness of the structure. As an example, this layer may be composed of a PSG material.

At step 148 the structure is patterned and vias are etched through the ILD stack (the thick insulating layer, the barrier layer, and the insulating layer) to expose the electrodes. Then, at step 150, metal layers are deposited and patterned to form interconnects to the electrodes. As an example, the metallic layers may be TiW/Al/TiW, TiW/Al, TiW/Pt/Au, TiN/Al, Ti/TiN/Al, Ti/TiW/Cu, or TiW/Cu. Finally, the silicon nitride hermetic seal layer is deposited in step 152 by PECVD, and it is patterned and etched to provide openings for the metal interconnects. Although not shown as a separate step, a metal bump layer (e.g., TiW/Au) connecting to the metal interconnects may then be deposited and etched to form bonding pads on the top surface of the structure. The top layer bonding pads may, for example, be used to connect with the bonding pads of an integrated circuit, forming an SoP structure.

Other steps, involving fabricating other layers may be added in between or after the steps shown in Figs. 23 and 24. Other layers may include layers promoting adhesion of the capacitor to the substrate or planarizing layer, buffer layers, high density interconnect (HDI) layers, and scratch-resistant, protective layers.

This written description uses examples to disclose the invention, including the best mode, and also to enable a person skilled in the art to make and use the invention. It should be understood that the examples depicted in the Figures may not be drawn to scale. The patentable scope of the invention may include other examples that occur to those skilled in the art.

For example, the technology disclosed above may be modified to include a conductive bump layer as a second level of interconnect along with a scratch-protection layer on top of this bump layer. The scratch protection layer can be patterned and etched to allow connection to an integrated circuit. Another bump layer may be added on top of this.

## Claims

1. A thin-film capacitor structure, comprising:
a substrate;
a thin-film capacitor attached to the substrate, the thin-film capacitor including a pyrochlore or perovskite dielectric layer between a plurality of electrode layers, the electrode layers being formed from a conductive thin-film material;
a pyrochlore or perovskite alkali earth titanate hydrogen-gettering barrier layer deposited over the thin-film capacitor;
a silicon nitride layer deposited over the barrier layer, the silicon nitride layer being deposited by plasma enhanced chemical vapor deposition (PECVD) or low pressure chemical vapor deposition (LPCVD).

2. The thin-film capacitor structure of claim 1, wherein the substrate includes an insulating and/or planarizing layer.

3. The thin-film capacitor structure of claims 1 or 2, wherein an insulating and/or planarizing layer is deposited over the thin-film capacitor

4. The thin-film capacitor structure of claim 3, wherein the insulating and planarizing layer is deposited over and adjacent to the thin-film capacitor.

5. The thin-film capacitor structure of any of claims 1 to 4, wherein a thick insulating layer is deposited over the thin-film capacitor.

6. The thin-film capacitor structure of claim 5, wherein the thick insulating layer is deposited over and adjacent to the barrier layer.

7. The thin-film capacitor structure of any of claims 1 to 6, wherein the silicon nitride layer is deposited as a hermetic seal over and adjacent to the thick insulating layer.

8. The thin-film capacitor structure of claim 4, wherein a thick insulating layer is deposited over and adjacent to the planarizing and/or insulating layer.

9. The thin-film capacitor structure of claim 8, wherein the barrier layer is deposited over and adjacent to the thick insulating layer.

10. The thin-film capacitor structure of any of claims 1 to 9, wherein the silicon nitride layer is deposited over and adjacent to the barrier layer.

11. The thin-film capacitor structure of any of claims 1 to 10, wherein a protective layer is deposited over the silicon nitride layer.

12. The thin-film capacitor structure of any of claims 1 to 11, wherein the barrier layer is a compound containing Barium Strontium Titanium Oxide.

13. The thin-film capacitor structure of any of claims 1 to 12, wherein the capacitor is a multi-level capacitor.

14. The thin-film capacitor structure of claim 13, wherein the multi-level capacitor is a tunable capacitor.

15. A System-on-a-Package (SoP) structure comprising the thin-film capacitor structure of any of claims 1 to 14 attached to an integrated circuit chip.

16. A hearing instrument comprising the thin-film capacitor structure of any of claims 1 to 14.

17. An integrated circuit comprising:
a substrate;
a capacitor including a pyrochlore or perovskite dielectric layer between a plurality of electrode layers;
a pyrochlore or perovskite alkali earth titanate hydrogen-gettering barrier layer deposited over the thin-film capacitor;
a layer deposited by a process that produces atomic hydrogen in a quantity sufficient to degrade the capacitor.

18. The integrated circuit of claim 17, wherein the process that produces atomic hydrogen in a sufficient quantity to degrade the capacitor is plasma enhanced chemical vapor deposition (PECVD) or low pressure chemical vapor deposition (LPCVD).

19. The integrated circuit of any of claims 17 to 18, wherein the layer deposited by a process that produces atomic hydrogen in a quantity sufficient to degrade the capacitor functions as a hermetic seal.

20. The integrated circuit of any of claims 17 to 19, wherein the layer is deposited by a process that produces atomic hydrogen in a quantity sufficient to degrade the capacitor is silicon nitride.

21. A method of manufacturing a capacitor structure, comprising the steps of:
fabricating a capacitor on a substrate, the capacitor having a pyrochlore or perovskite dielectric layer;
depositing a pyrochlore or perovskite alkali earth titanate hydrogen-gettering layer over the capacitor;
depositing a silicon nitride hermetic seal layer by PECVD or LPCVD over the hydrogen barrier layer.

22. The method of claim 21, further comprising the step of:
patterning and etching pad openings in the capacitor structure.

23. The method of claims 21 or 22, further comprising the step of:
depositing a planarizing and/or insulating layer.

24. The method of any of claims 21 to 23, further comprising the step of:
depositing a thick insulating layer.

25. The method of claim 22, further comprising the step of:
depositing and patterning metal layers to form interconnects.

26. The method of any of claims 21 to 25, wherein the pyrochlore or perovskite hydrogen barrier layer is a compound containing Barium Titanate, Strontium Titanate, Magnesium Titanate, Calcium Titanate, or a mixture of these.

27. The thin-film capacitor structure of any of claims 1 to 14, wherein the pyrochlore or perovskite hydrogen barrier layer is a compound containing Barium Titanate, Strontium Titanate, Magnesium Titanate, Calcium Titanate, or a mixture of these.
